(19) Europäisches Patentamt / European Patent Office / Office européen des brevets

(11) **EP 3 128 390 A1**

(12) **EUROPEAN PATENT APPLICATION**

(43) Date of publication:
**08.02.2017  Bulletin 2017/06**

(51) Int Cl.:
**G05F 3/20** (2006.01)    **G01K 7/00** (2006.01)

(21) Application number: **16179457.3**

(22) Date of filing: **14.07.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **07.08.2015  JP 2015156965**

(71) Applicant: **NEC Space Technologies, Ltd. Fuchu-shi Tokyo (JP)**

(72) Inventor: **SAKATA, Tomo Tokyo (JP)**

(74) Representative: **Vossius & Partner Patentanwälte Rechtsanwälte mbB Siebertstrasse 3 81675 München (DE)**

(54) **TEMPERATURE-COMPENSATED VOLTAGE DIVIDER CIRCUIT**

(57)    Provided is a temperature-compensated voltage divider circuit suppressing non-linearity of a divided voltage. A temperature-compensated voltage divider circuit includes a first voltage divider unit in which a plurality of diodes are connected in series, an one end thereof is an anode end, and the other end thereof is a cathode end, and a second voltage divider unit which is connected to the first voltage divider unit, the second voltage divider unit including a resister and a temperature compensator which are connected in parallel, the temperature compensator having a substantially linear temperature characteristic and suppressing temperature change of the resister.

FIG. 1

EP 3 128 390 A1

**Description**

**INCORPORATION BY REFERENCE**

This application is based upon and claims the benefit of priority from Japanese Patent Application No. 2015-156965, filed on August 7, 2015, the disclosure of which is incorporated herein in its entirety by reference.

**TECHNICAL FIELD**

The invention relates to a temperature-compensated voltage divider circuit which is temperature-compensated.

**BACKGROUND ART**

A resistance value of a resister changes depending on temperature. It is, however, required in some cases that a constant resistance value be maintained regardless of temperature. In such case, a temperature-compensated voltage divider circuit is used.

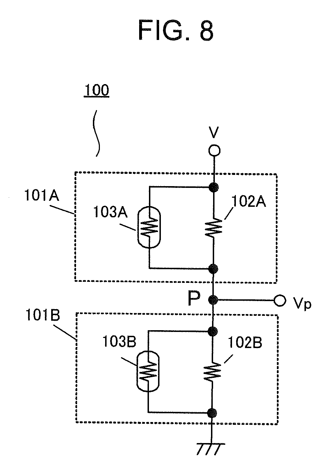

Fig. 8 illustrates an example of such temperature-compensated voltage divider circuit 100. In the temperature-compensated voltage divider circuit 100, a first voltage divider unit 101A and a second voltage divider unit 101B are connected in series, and a power source voltage V is divided at a voltage dividing point P (divided voltage is described as Vp). The first voltage divider unit 101A includes a voltage dividing resister 102A and a temperature compensator 103A which is connected thereto in parallel. The second voltage divider unit 101B includes a voltage dividing resister 102B and a temperature compensator 103B which is connected thereto in parallel. The temperature compensator 103A and the temperature compensator 103B are disposed to compensate non-linear temperature characteristics of the resister 102A and the resister 102B, respectively. The power source voltage V is a negative voltage in the example.

The divided voltage Vp is determined by a resistance ratio between the first voltage divider unit 101A and the second voltage divider unit 101B. If the first voltage divider unit 101A and the second voltage divider unit 101B have non-linear temperature characteristics, the divided voltage Vp is also non-linear.

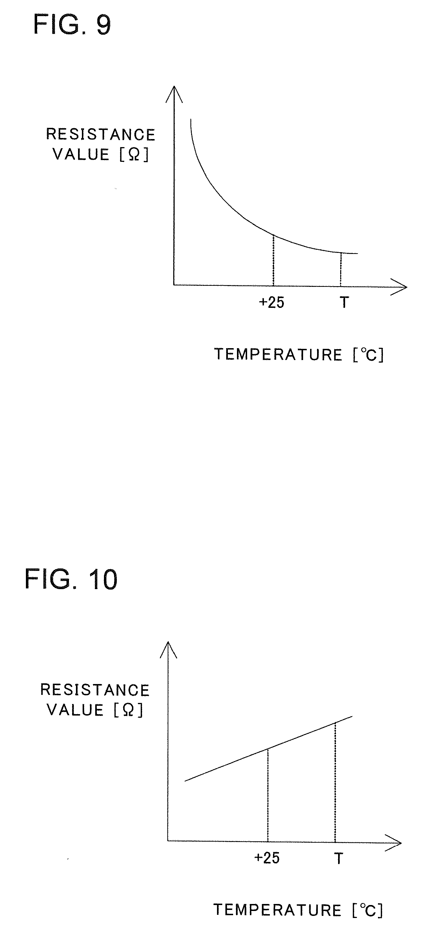

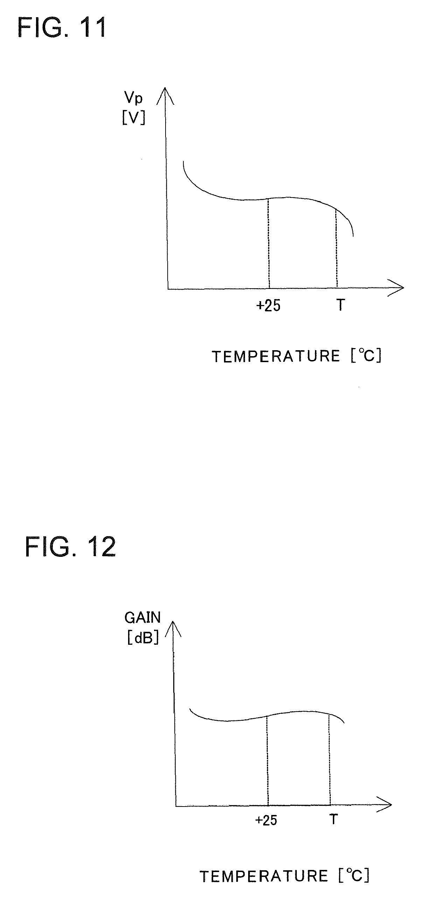

Fig. 9 illustrates a resistance-temperature characteristic of a negative temperature coefficient thermistor, and Fig. 10 illustrates a resistance-temperature characteristic of a positive temperature coefficient sensistor. In Fig. 8, the negative temperature coefficient thermistor of Fig. 9 is used as the temperature compensator 103A and the positive temperature coefficient sensistor of Fig. 10 is used as the temperature compensator 103B. In this case, the divided voltage Vp at the voltage dividing point P has a non-linear temperature characteristic as illustrated in Fig. 11.

In devices in which gain is controlled based on such the divided voltage, gain changes non-linearly with respect to temperature as shown in Fig. 12.

For example, Japanese Patent Application Laid-Open No. Hei 8-272465 proposes a voltage divider circuit 110 as shown in Fig. 13. In the voltage divider circuit 110, a diode circuit 111 is configured by connecting a plurality of diodes 111_1 to 111_n in series, and a resister 112 is connected to the diode circuit 111 in series. A voltage generated across both ends of the voltage divider circuit 110 is used as the divided voltage Vp. The divided voltage Vp is controlled by adjusting the number of the diodes to be connected and/or a resistance value of the resister.

In the configuration of Japanese Patent Application Laid-Open No. Hei 8-272465, even if temperature-dependence of the diode circuit 111 is small, temperature-dependence of the divided voltages Vp is generated since the resister 112 has temperature-dependence. If the resister 112 has non-linear temperature characteristic, the divided voltage Vp at voltage dividing point P becomes non-linear.

Microfilm of the specification and drawings annexed to the request of Japanese Utility Model Application No. Sho 61-90597 (Laid-Open No. Sho 62-203511) relates to a temperature compensation circuit, and proposes that gain of an amplifier is kept constant with respect to temperature change. Japanese Patent Application Laid-Open No. 2003-78358 relates to a FET (Field Effect Transistor) amplifier, and proposes to compensate temperature change of FET gain effectively.

**SUMMARY**

This invention provides a temperature-compensated voltage divider circuit which suppresses non-linearity of a divided voltage.

[Means for Solving the Problem]

In order to achieve the above-mentioned object, a temperature-compensated voltage divider circuit according to the present invention that divides a potential difference between a high-potential end and a low-potential end in a terminal part comprising the high-potential end and the low-potential end whose potential is lower than that of the high-potential end, performs temperature compensation so that a divided voltage changes at least linearly with respect to temperature change, and outputs the divided voltage, the temperature-compensated voltage divider circuit comprises:

a first voltage divider unit wherein a plurality of diodes are connected in series, an one end thereof is an anode side end, and the other end thereof is a cathode side end; and
a second voltage divider unit that is connected to the first voltage divider unit, the second voltage divider unit comprising a resister and a temperature compensator that are connected in parallel, the temperature compensator having a substantially linear temperature characteristic and suppressing temperature change of the resister.

[Advantageous Effect of the Invention]

In the invention, a temperature-compensated voltage divider circuit includes a first voltage divider unit having a diode with linear temperature dependence and a second voltage divider unit in which temperature dependence of a resister is compensated by a temperature compensator with linear temperature dependence. Therefore, the circuit can output a divided voltage in which non-linearity is suppressed.

## BRIEF DESCRIPTION OF THE DRAWINGS

Exemplary features and advantages of the present invention will become apparent from the following detailed description when taken with the accompanying drawings in which:

Fig. 1 illustrates a temperature-compensated voltage divider circuit of an exemplary embodiment,
Fig. 2 illustrates a graph indicating a temperature coefficient of relation between temperature and a forward direction voltage in a diode,
Fig. 3 illustrates a divided voltage characteristic which is linearly compensated in the positive direction,
Fig. 4 illustrates an ideal gain characteristic which does not depend on temperature in a gain control element,
Fig. 5 illustrates a temperature-compensated voltage divider circuit in which a second voltage divider unit is arranged on a power source side and a first voltage divider unit is arranged on a ground side,
Fig. 6 illustrates a temperature-compensated voltage divider circuit in which connection of the first voltage divider unit and the second voltage divider unit in the temperature-compensated voltage divider circuit shown in Fig. 1 is reversed,
Fig. 7 illustrates a temperature-compensated voltage divider circuit in which connection of the first voltage divider unit and the second voltage divider unit in the temperature-compensated voltage divider circuit shown in Fig. 5 is reversed,
Fig. 8 illustrates a configuration of a temperature-compensated voltage divider circuit to be used for explanations on a related technology,
Fig. 9 illustrates a resistance temperature characteristic of a negative temperature coefficient thermistor,
Fig. 10 illustrates a resistance temperature characteristic of a positive temperature coefficient sensistor,
Fig. 11 illustrates a divided voltage which is generated when the positive temperature coefficient sensistor is used,
Fig. 12 illustrates a gain characteristic which is controlled on the basis of the divided voltage shown in Fig. 11, and

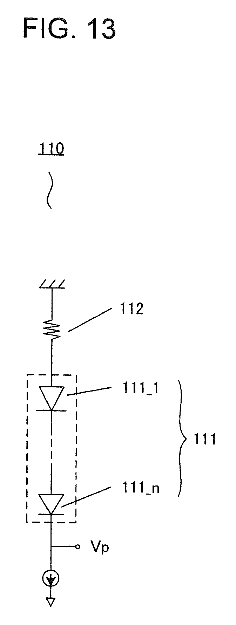

Fig. 13 illustrates a voltage divider circuit for explanations on a technology of a related art.

## EXEMPLARY EMBODIMENT

Next, a detailed explanation will be given for an exemplary embodiment of the present invention with reference to the drawings.

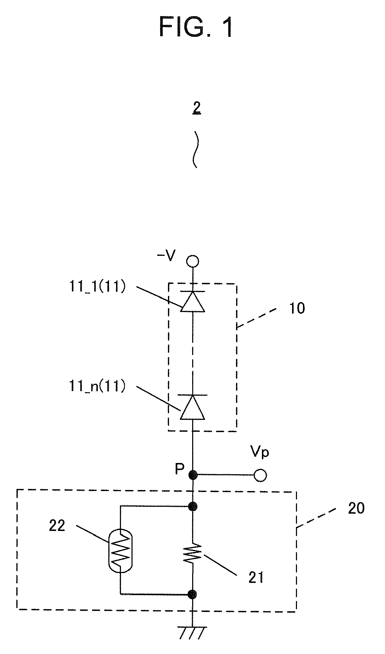

Fig. 1 illustrates a temperature-compensated voltage divider circuit 2 according to the present exemplary embodiment. In the temperature-compensated voltage divider circuit 2, a first voltage divider unit 10 is arranged on the low-potential end side, and a second voltage divider unit 20 is arranged on the high-potential end side. A connection point P of the first voltage divider unit 10 and the second voltage divider unit 20 is a voltage dividing point. In following explanations, it is assumed that a power source is at the low-potential end and ground is at the high-potential end. The voltage of the power source is negative, a voltage value of the power source is -V, and a voltage at the connection point P (divided voltage) is Vp.
The first voltage divider unit 10 is composed of a plurality of diodes 11 (11_1 to 11_n) which are connected in series. The "n" is a positive integer. The diodes 11 are each connected so as to line up in the forward direction, and a temperature characteristic of a forward voltage thereof has a negative temperature coefficient if a forward current is constant.

The plurality of diodes 11 are connected in series, one end of the diodes 11 forms an anode side end portion, and the other end thereof forms a cathode side end portion. In Fig. 1, the cathode side end is connected to the power source which forms the low-potential end, and the anode side end is connected to the second voltage divider unit 20. A forward bias is therefore applied to the diodes 11.

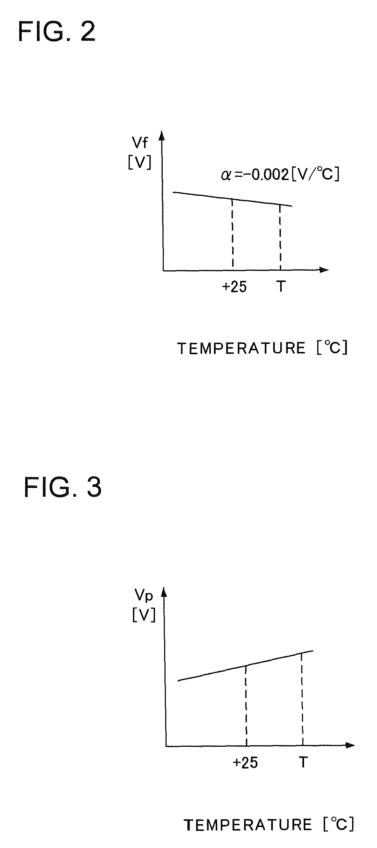

Fig. 2 illustrates a graph indicating a temperature coefficient representing relation between a temperature T and a forward voltage Vf in the diodes. Fig. 2 discloses a case in which a temperature coefficient $\alpha$ is equal to -0.002 (V/°C) as an example.

In the second voltage divider unit 20, a resister 21 and a temperature compensator 22 are connected in parallel. For example, a thermistor may be used as the temperature compensator 22. In this case, if a resistance value of the resister 21 is increased as temperature rises (positive characteristic), a thermistor whose resistance value is decreased as the temperature rises (negative characteristic) is available as the temperature compensator 22. If a resistance value of the resister 21 is decreased as temperature rises (negative characteristic), a thermistor whose resistance value is increased as the temperature rises (positive characteristic) is available as the temperature compensator 22.

Thereby temperature dependence of a combined resistance value Rc of the resister 21 and the temperature compensator 22 can be suppressed. The divided voltage Vp is determined in view of a combined resistance value of the first voltage divider unit 10. Therefore temperature dependence may occur in the divided voltage Vp, even if the combined resistance Rc of the second voltage divider unit 20 has no temperature dependence. In the exemplary embodiment of the present invention, the plurality of diodes 11 are connected in series so that temperature dependence of the second voltage divider unit 20 can be suppressed.

The divided voltage Vp at the voltage dividing point P can be described as follows. The divided voltage is denoted as Vp[T] in order to represent that values of the divided voltage Vp, etc. are functions of temperature. A divided voltage Vp[25] represents a value at a room temperature (25°C).

When a resistance value of the temperature compensator 22 is denoted as Rt[25], a resistance value of the resister 21 is denoted as R[25], and a combined resistance value of the temperature compensator 22 and the resister 21 is denoted as Rc[25], the following equation is given.

$$Rc[25] = 1/(1/R[25]+1/Rt[25])$$

Thus, a current I which flows at the voltage dividing point P can be described as follows:

$$I = Vp[25]/Rc[25]$$
$$= (Vp[25] \times R[25] \times Rt[25])/(R[25]+Rt[25]) \ ...(2)$$

If a forward voltage is denoted as $Vf_i(I)[25]$ when a current I flows in diodes 11_1 to 11_n, the divided voltage Vp[25] at the voltage dividing point P is given as

$$Vp = V + \Sigma \, Vf_i(I)[25] \quad ...(1)$$

where $\Sigma$ means the sum over i=1, 2, ..., n.

Next, the divided voltage Vp[T] at a temperature T (T≧25°C) is explained. A typical value, -0.002 (V/°C), is used as a temperature coefficient $\alpha$ of a forward voltage in the diode 11 (a= -0.002 (V/°C). As a resistance temperature coefficient $\beta$ of a resistance value Rt in the temperature compensator 22, 5000 (ppm/°C) ($\beta$= 5000 (ppm/°C)) is used. The values described above are examples.

In this case, the divided voltage Vp[T] at a temperature T is denoted as

$$Vp[T] = (V + \Sigma Vf_i(I)) \times (1+\alpha) \times (T-25)$$
$$= (V + \Sigma Vf_i(I)) \times (1+-0.002) \times (T-25) \ ...(3)$$

where $\Sigma$ means the sum over i=1, 2, ..., n.

The current I is given as follows.

$$I = Vp[T]/Rc[T]$$
$$= (Vp[T] \times R[T] \times Rt[T])/(R[T]+Rt[T]) \ldots(4)$$

The resistance Rt[T] of the temperature compensator 22 is given as follows.

$$Rt[T] = Rt[25] + (\beta \times Rt[25] \times (T-25))/10^6$$
$$= Rt[25] + (5000 \times Rt[25] \times (T-25))/10^6 \ldots(5)$$

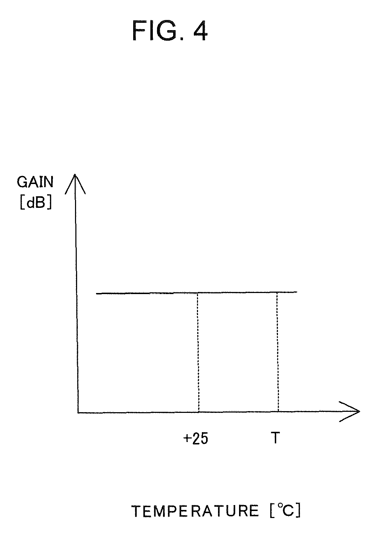

The equations (3) to (5) show the divided voltage Vp[T] is a positive linear function of temperature T. Thereby, as exemplified in Fig. 3, it is possible to linearly compensate the divided voltage Vp in the positive direction with respect to temperature T. In an ideal case, as shown in Fig. 4, gain of a gain control element can be constant without depending on temperature.

It should be noted that variation of the divided voltage Vp is sufficiently suppressed with respect to temperature change and remaining temperature dependence linearly changes with respect to the temperature. This allows the divided voltage Vp to vary linearly, thereby deterioration of the gain temperature characteristic of the gain control element can be suppressed.

Accordingly, by connecting the plurality of diodes 11 in series and using the forward voltage linear temperature characteristic in each diode 11, temperature compensation can be performed in such a way that the divided voltage Vp linearly changes with respect to temperature.

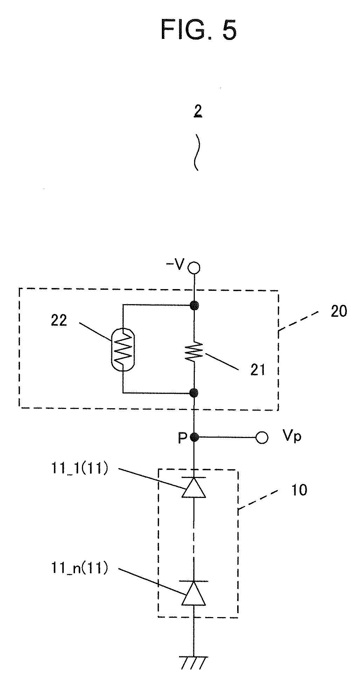

In the above explanations of the embodiment, the first voltage divider unit 10 is arranged on the power source side and the second voltage divider unit 20 is arranged on the ground side. However, the other circuit configuration may also be used. For example, the second voltage divider unit 20 may be arranged on a power source side and the first voltage divider unit 10 may be arranged on a ground side, as illustrated in Fig. 5.

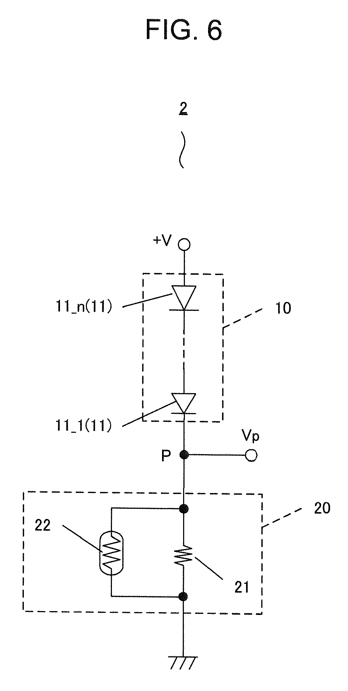

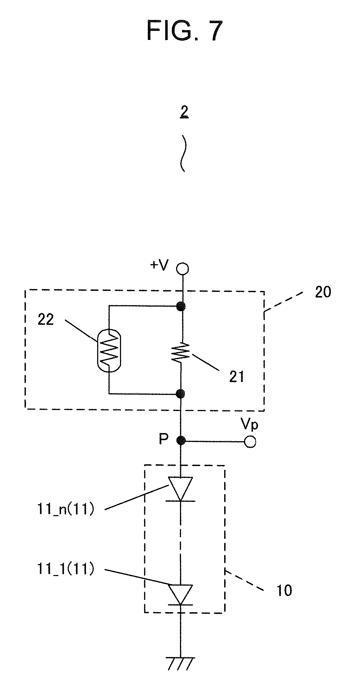

The power source with a negative voltage is used and explained above. However, a positive voltage may also be used as the power source. In the case, as shown in Figs. 6 and 7, a reversed circuit connection opposite to the connection shown in Figs. 1 and 5 is formed in such a way that a forward voltage is applied to the diodes forming the first voltage divider unit 10.

The previous description of embodiments is provided to enable a person skilled in the art to make and use the present invention. Moreover, various modifications to these exemplary embodiments will be readily apparent to those skilled in the art, and the generic principles and specific examples defined herein may be applied to other embodiments without the use of inventive faculty. Therefore, the present invention is not intended to be limited to the exemplary embodiments described herein but is to be accorded the widest scope as defined by the limitations of the claims and equivalents.

Further, it is noted that the inventor's intent is to retain all equivalents of the claimed invention even if the claims are amended during prosecution.

[Reference Signs List]

| | |
|---|---|
| 2 | temperature-compensated voltage divider circuit |
| 10 | first voltage divider unit |
| 11 (11_1 to 11_n) | diode |
| 20 | second voltage divider unit |
| 21 | resister |
| 22 | temperature compensator |

**Claims**

1. A temperature-compensated voltage divider circuit that divides a potential difference between a high-potential end and a low-potential end, performs temperature compensation, and outputs a temperature-compensated divided voltage, the high-potential end and the low-potential end constituting a terminal part, the low-potential end being at a potential lower than that of the high-potential end, the temperature compensation being performed in such a way that the temperature-compensated divided voltage changes at least linearly with respect to temperature change, the temperature-compensated voltage divider circuit comprising:

a first voltage divider unit wherein a plurality of diodes are connected in series, an one end thereof being an anode side end, and the other end thereof being a cathode side end; and
a second voltage divider unit that is connected to the first voltage divider unit, the second voltage divider unit including a resister and a temperature compensator that are connected in parallel, the temperature compensator having a substantially linear temperature characteristic and suppressing temperature change of the resister.

2. The temperature-compensated voltage divider circuit according to claim 1, wherein the cathode side end of the first voltage divider unit is arranged on a low-potential end side in such a way that a forward bias is applied to the plurality of diodes.

3. The temperature-compensated voltage divider circuit according to claim 1 or claim 2, wherein the temperature compensator has a negative characteristic if a temperature characteristic of the resister has a positive temperature coefficient, and has a positive characteristic if the temperature characteristic of the resister has a negative temperature coefficient.

4. The temperature-compensated voltage divider circuit according to any one of claim 1 to claim 3, wherein the temperature compensator is a thermistor.

# FIG. 1

2

-V

11_1(11)

10

11_n(11)

Vp

P

20

22

21

FIG. 2

Vf
[V]

$\alpha = -0.002 [V/^{\circ}C]$

+25    T

TEMPERATURE [℃]

FIG. 3

Vp
[V]

+25    T

TEMPERATURE [℃]

# FIG. 4

# FIG. 5

2

-V ○

22

21

20

P ● ○ Vp

11_1(11)

10

11_n(11)

///

# FIG. 6

2

+V

11_n(11)

10

11_1(11)

Vp

P

22

21

20

# FIG. 7

2

+V

22

21

20

P

Vp

11_n(11)

11_1(11)

10

# FIG. 8

# FIG. 9

RESISTANCE
VALUE [Ω]

+25    T

TEMPERATURE [°C]

# FIG. 10

RESISTANCE
VALUE [Ω]

+25    T

TEMPERATURE [°C]

FIG. 11

FIG. 12

# FIG. 13

110

112

111_1

111

111_n

Vp

Europäisches
Patentamt

European
Patent Office

Office européen
des brevets

**EUROPEAN SEARCH REPORT**

Application Number

EP 16 17 9457

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 202 190 434 U (DONGGUAN ANPEILONG ELECTRONIC TECHNOLOGY CO LTD) 11 April 2012 (2012-04-11) * abstract; figure 1 * | 1-4 | INV. G05F3/20 G01K7/00 |
| X | JP S50 110255 A (HITACHI) 30 August 1975 (1975-08-30) * abstract; figure 1 * | 1-4 | |
| X | US 3 934 476 A (LAMB II HARRY H) 27 January 1976 (1976-01-27) * abstract; figure 1 * | 1-4 | |
| A | Maxim Integrated: "APP 817 Using Thermistors in Temperature Tracking Power Supplies", , 29 November 2001 (2001-11-29), pages 1-13, XP055328553, Retrieved from the Internet: URL:http://pdfserv.maximintegrated.com/en/an/AN817.pdf [retrieved on 2016-12-13] * page 3 - page 4 * | 1-4 | TECHNICAL FIELDS SEARCHED (IPC) G05F G01K |
| Y | US 3 972 237 A (TURNER ROBERT BRUCE) 3 August 1976 (1976-08-03) * abstract; figure 5 * | 1-4 | |

-/--

The present search report has been drawn up for all claims

| Place of search | Date of completion of the search | Examiner |
|---|---|---|
| The Hague | 21 December 2016 | Arias Pérez, Jagoba |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

    .................................................................
& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 16 17 9457

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | ROBERT GREGOIRE B ET AL: "Process-Independent Resistor Temperature-Coefficients using Series/Parallel and Parallel/Series Composite Resistors", CIRCUITS AND SYSTEMS, 2007. ISCAS 2007. IEEE INTERNATIONAL SYMPOSIUM O N, IEEE, PI, 1 May 2007 (2007-05-01), pages 2826-2829, XP031181892, ISBN: 978-1-4244-0920-4 * page 2826 - page 2827 * | 1-4 | |

-----

|  |  |
|---|---|
| | **TECHNICAL FIELDS SEARCHED (IPC)** |

The present search report has been drawn up for all claims

| Place of search | Date of completion of the search | Examiner |
|---|---|---|
| The Hague | 21 December 2016 | Arias Pérez, Jagoba |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                      

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 16 17 9457

This annex lists the patent family members relating to the patent documents cited in the above-mentioned European search report.
The members are as contained in the European Patent Office EDP file on
The European Patent Office is in no way liable for these particulars which are merely given for the purpose of information.

21-12-2016

| Patent document cited in search report | | Publication date | Patent family member(s) | Publication date |
|---|---|---|---|---|
| CN 202190434 | U | 11-04-2012 | NONE | |
| JP S50110255 | A | 30-08-1975 | NONE | |
| US 3934476 | A | 27-01-1976 | NONE | |
| US 3972237 | A | 03-08-1976 | NONE | |

EPO FORM P0459

For more details about this annex : see Official Journal of the European Patent Office, No. 12/82

# EP 3 128 390 A1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015156965 A
- JP HEI8272465 A
- JP SHO6190597 A
- JP SHO62203511 B
- JP 2003078358 A